# EUROPÄISCHE PATENTSCHRIFT

(11) **EP 0 528 301 B1**
(45) Veröffentlichungstag und Bekanntmachung des Hinweises auf die Patenterteilung: **20.03.1996**
(21) Anmeldenummer: 92113517.4
(22) Anmeldetag: 07.08.1992
(51) Int. Cl.: E04B 1/92, H05K 9/00

(54) **Magnetische Abschirmkabine mit zusätzlicher Schirmung**
Magnetically shielded cabin with supplementary shield
Cabine d'isolation magnétique avec isolation supplémentaire

(30) Priorität: 13.08.1991 DE 4126690
(43) Veröffentlichungstag der Anmeldung: 24.02.1993
(73) Patentinhaber: VACUUMSCHMELZE GMBH, D-63412 Hanau (DE)
(72) Erfinder: Best, Karl Jürgen, Dr., W-6450 Hanau 1 (DE); Weber, Hartwin, Dr., W-6450 Hanau 1 (DE)
(74) Vertreter: Fuchs, Franz-Josef, Dr.-Ing.

(56) Entgegenhaltungen:
- DE-A- 3 543 687
- US-A- 4 841 692
- US-A- 4 959 504
- US-A- 5 017 736
- ELEKTROTECHNISCHE ZEITSCHRIFT ETZ Bd. 110, Nr. 16, 1989, Seiten 814 - 819 , XP54981 BEST & BORK 'Abschirmkabinen in medizinischer Diagnose und Halbleiter-Technologie'

## Beschreibung

Die Erfindung betrifft eine Vorrichtung zur Abschirmung des Innenraumes einer Abschirmkabine, die aus mindestens zwei an einer Trägerkonstruktion befestigten Schalen aus magnetisch und / oder elektrisch gut leitendem Material besteht.

Eine derartige Abschirmkabine ist beispielsweise in dem Aufsatz von K.-J. Best und J. Bork in "etz", Bd. 110 (1989) Heft 16, Seiten 814 - 818 beschrieben. In Bild 2 auf Seite 816 ist eine dreischalige magnetische Abschirmkabine dargestellt, die aus zwei mit Abstand voneinander an einer Trägerkonstruktion befestigten magnetischen Schalen und einer Leitfähigkeitsschale aus gut elektrisch leitendem Material besteht. Mit einer derartigen Abschirmkabine erreicht man - wie aus Bild 3 dieser Veröffentlichung hervorgeht - bei sehr niedrigen Frequenzen einen Abschirmfaktor von 50 bis 100, d. h., daß ein außen wirkendes Gleichfeld im Innenraum auf ein fünfzigstel bis ein hundertstel abgeschirmt wird. Mit derartigen magnetischen Abschirmkammern ist es möglich, mit Hilfe von Squids für die Messung von biomagnetischen Feldern Ströme im Innern des menschlichen Körpers zu messen und zu lokalisieren.

Es gibt allerdings auch besonders empfindliche Meßgeräte, bei denen die Abschirmwirkung einer beispielsweise zwei- oder dreischaligen Abschirmkammer nicht ausreicht, da besonders kleine Magnetfelder innerhalb des abgeschirmten Raumes gemessen werden sollen. Für derartige Messungen ist in dem obengenannten Aufsatz eine siebenschalige Kabine beschrieben, bei der jetzt nicht mehr eine Trägerkonstruktion für zwei bis drei Schalen verwendet wird, sondern bei denen die Schalen mit Abstand voneinander durch amagnetische und isolierende Verbindungswände miteinander verbunden sind. Dies ist erforderlich, da zur Erzeugung einer guten Abschirmwirkung immer ein Abstand zwischen benachbarten, magnetisch gut leitfähigen Schalen erforderlich ist. Dies bedingt gegenüber der im obengenannten Aufsatz beschriebenen Standardkabine mit zwei an einer Trägerkonstruktion befestigten magnetischen Schalen und einer Leitfähigkeitsschale einen erheblich größeren Aufwand, der nicht nur durch die zusätzlich erforderlichen magnetisch leitfähigen Schalen bedingt ist, sondern auch durch die ebenfalls notwendigen zusätzlichen Tragkonstruktionen hervorgerufen wird.

Aufgabe der vorliegenden Erfindung ist es, eine Vorrichtung zur Abschirmung des Innenraumes einer Abschirmkabine anzugeben, bei der die Abschirmwirkung der Gesamtanordnung wesentlich gegenüber der Abschirmwirkung der Abschirmkabine selbst erhöht ist, ohne daß zusätzliche Trägerkonstruktionen erforderlich sind.

Diese Aufgabe wird erfindungsgemäß dadurch gelöst, daß die Abschirmkabine zur Verbesserung der Abschirmwirkung mit Abstand in einem Kabinenraum aufgestellt ist, dessen Wände einschließlich Decke und Fußboden ebenfalls mit mindestens einer Schale aus magnetisch und / oder elektrisch gut leitendem Material verbunden sind.

Ein Ausführungsbeispiel der erfindungsgemäßen Anordnung ist in den Figuren dargestellt. Es zeigen:
- Fig. 1: einen Querschnitt von oben betrachtet und
- Fig. 2: einen Querschnitt von der Seite, während in
- Fig. 3: die Abhängigkeit des berechneten Schirmfaktors vom Abstand zwischen Abschirmkabine und Innenauskleidung des Kabinenraumes aufgetragen ist.

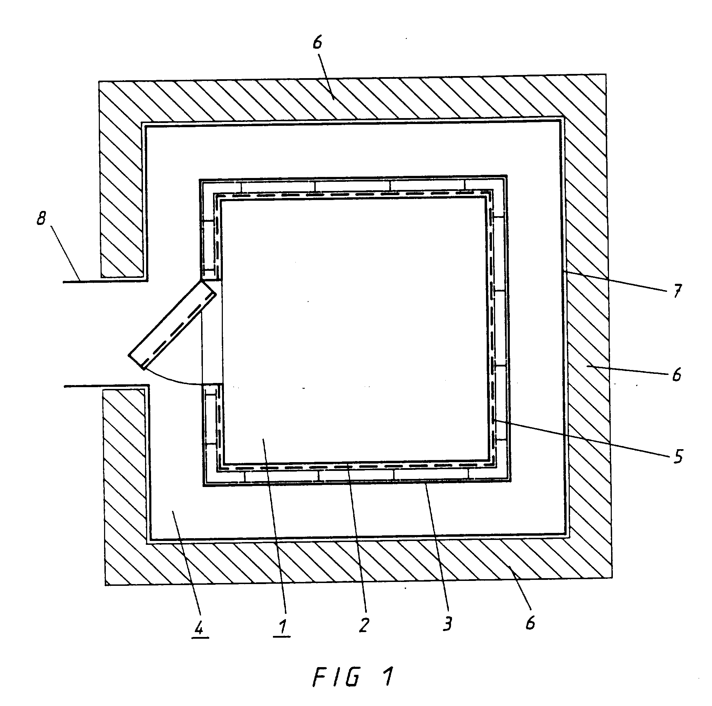

In Fig. 1 ist die Abschirmkabine 1 mit einer inneren Schale 2 aus hochpermeablem weichmagnetischem Material und einer äußeren Schale 3 aus dem gleichen Material innerhalb eines Kabinenraumes 4 aufgestellt. Außer den Schalen 2 und 3 besitzt die Abschirmkabine noch eine Leitfähigkeitsschale 5, die z. B. aus Kupfer oder Aluminium bestehen kann. Der Raum wird von Wänden 6 umgeben, die an der Innenseite mit einer weiteren Schale 7 aus hochpermeablen Material versehen ist. Die Schale 7 ist im Eingangsbereich nach außen weitergezogen und bildet so einen ebenfalls abgeschirmten Zugangstunnel 8.

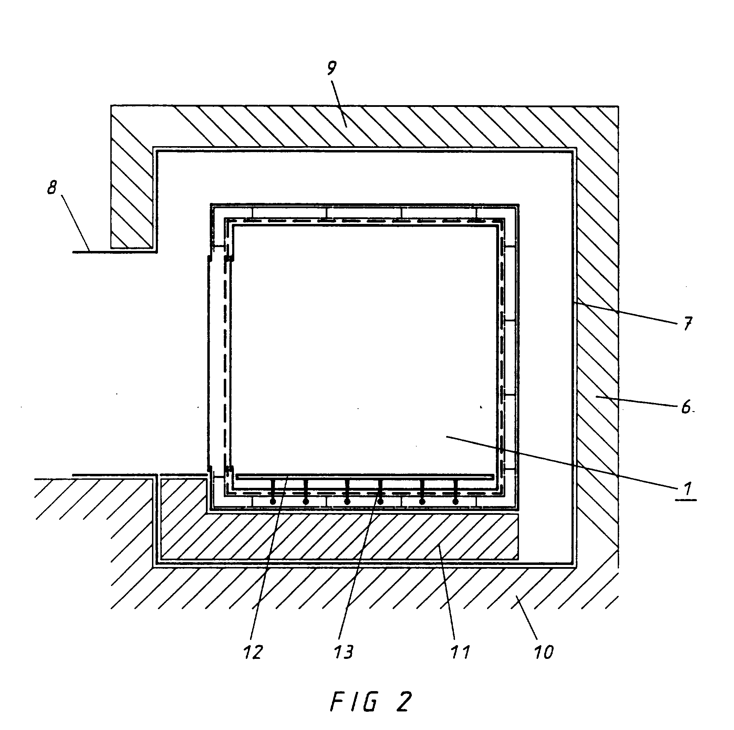

In der Seitenansicht nach Fig. 2 ist zu sehen, daß außerdem die Decke 9 und der Boden 10 ebenfalls mit der Schale 7 aus hochpermeablem Material verkleidet sind. Die Abschirmkammer 1 stützt sich dabei auf einem Fundament 11 ab, dessen Dicke etwa so groß ist wie der Abstand zwischen der Decke der Abschirmkammer 1 und der Decke 9 des Kabinenraumes. Die Schale 7 kann dabei zwischen dem Boden 10 und dem Fundament 11 schwimmend gelagert sein. Sie ist dazu beispielsweise zwischen Lagen von Gummi oder ähnlichen Materialien eingebettet, oder es sind andere Abstandshalter oder dgl. vorgesehen, um mechanische Beanspruchungen von der Schale 7 fernzuhalten. Man kann aber auch die Schale 7 zwischen Fundament 11 und Boden 10 eingießen, so daß ein einziger Gußblock entsteht. Dies ist in entsprechender Weise ebenso für die Wände oder für die Decke des Raumes, in dem die Abschirmkabine steht, möglich.

In bekannter Weise ist der eigentliche Fußboden 12 der Abschirmkammer über Stützen 13 an der Trägerkonstruktion der Abschirmkammer 1 abgestützt, um mechanische Beanspruchungen von der weichmagnetischen Schale 2 des Bodens der Abschirmkammer 1 fernzuhalten.

Bei einer derartigen Anordnung erhält man die in Tabelle 1 aufgeführten Schirmfaktoren abhängig vom Abstand zwischen Abschirmkabine und den ausgekleideten Wänden des Kabinenraumes bei verschiedenen Schichtdicken der einzelnen Schalen (Tabelle 1).

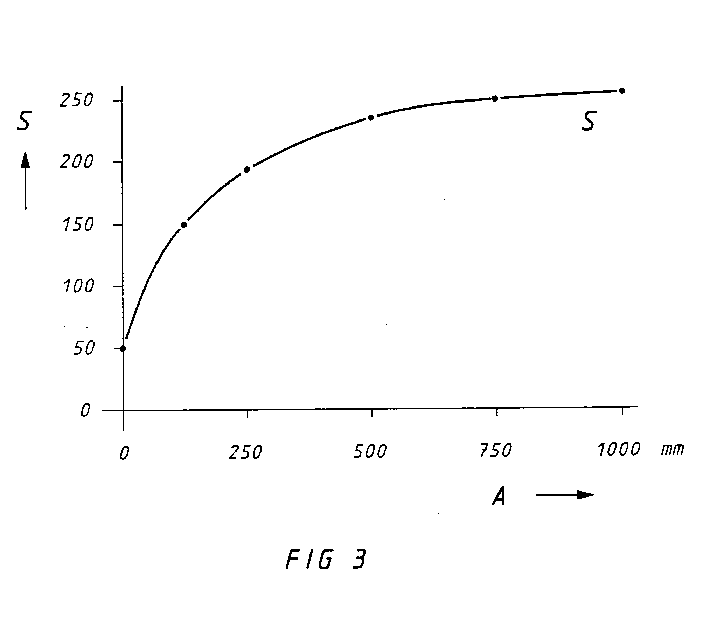

Fig. 3 zeigt in grafischer Darstellung die Abhängigkeit des Schirmfaktors S von dem Abstand A zwischen Abschirmkabine und Wand des Kabinenraumes. Aus diesem Verlauf kann man sehen, daß sich eine erhebliche Steigerung des Schirmfaktors durch Aufstellung einer Abschirmkabine in einem mit einer weichmagnetischen Schale 7 ausgekleideten Kabinenraum ergibt. Die Kurve S in Fig. 3 zeigt weiterhin, daß sich bei zunehmendem Abstand nur noch kleine Zuwächse des Schirmfaktors ergeben. Dies liegt an Sättigungserscheinungen in den äußeren Schalen der Abschirmvorrichtung, wie aus der Tabelle 1 zu ersehen ist, da eine Vergrößerung der Schichtdicke von 2 auf 3 mm in der äußeren Schale 7 eine Steigerung des Schirmfaktors von 255 auf 350 bewirkt. Bei der Wahl einer Schichtdicke von 3 mm auch für die äußere weichmagnetische Schale der Abschirmkabine erhält man einen Schirmfaktor von 450.

Im Ausführungsbeispiel ist die Schale 7, welche die Wände, die Decke und den Boden des Kabinenraumes bedeckt, an der Innenseite dieser Mauern befestigt. Sie kann selbstverständlich auch in die Mauer integriert sein oder die Außenflächen der Mauern, Decke und Boden bedecken. Eine weiter verbesserte Abschirmwirkung läßt sich dann noch erreichen, wenn sowohl die Innenseiten als auch die Außenseiten des die Abschirmkabine umgebenden Mauerwerks mit je einer Schale aus magnetisch gut leitendem Material bedeckt sind.

In dem Ausführungsbeispiel nach Fig. 1 und 2 ist der Zugang zum Kabinenraum tunnelförmig ausgebildet, und die äußere Schale 7 ist in diesen Zugangstunnel 8 vorgezogen, so daß außer der normalerweise vorhandenen Kabinentür keine weitere Tür erforderlich ist. Selbstverständlich läßt sich auch eine zusätzliche Tür, beispielsweise eine Schiebetür, die ebenfalls mit weichmagnetischem Material ausgekleidet ist, ebenfalls verwenden.

**Tabelle 1**

| Berechneter Schirmfaktor für eine Abschirmkabine in einem magnetisch geschirmten Kabinenraum bei unterschiedlichen Abständen zwischen der äußeren Schale (3) der Abschirmkabine und der Schale (7) an Wand, Decke und Boden des Kabinenraumes bei einer Störfrequenz von 0.01 Hz sowie bei unterschiedlichen Schichtdicken der Schalen | | | | | |
|---|---|---|---|---|---|
| Abstand mm | Schirmfaktor | Schale 2 Mumetall | Schale 5 Al | Schale 3 Mumetall | Schale 7 Mumetall |
| --- | 50 | 3mm | 8mm | 2mm | --- |
| 125 | 150 | 3mm | 8mm | 2mm | 2mm |
| 250 | 190 | 3mm | 8mm | 2mm | 2mm |
| 500 | 240 | 3mm | 8mm | 2mm | 2mm |
| 750 | 250 | 3mm | 8mm | 2mm | 2mm |
| 1000 | 255 | 3mm | 8mm | 2mm | 2mm |
| 1000 | 350 | 3mm | 8mm | 2mm | 3mm |
| 1000 | 450 | 3mm | 8mm | 3mm | 3mm |

## Patentansprüche

1. Vorrichtung zur Abschirmung des Innenraumes einer Abschirmkabine (1), die aus mindestens zwei an einer Trägerkonstruktion befestigten Schalen (2, 3, 5) aus magnetisch und / oder elektrisch gut leitendem Material besteht, **dadurch gekennzeichnet,** daß die Abschirmkabine (1) zur Verbesserung der Abschirmwirkung mit Abstand in einem Kabinenraum (4) aufgestellt ist, dessen Wände (6) einschließlich Decke (9) und Fußboden (10) ebenfalls mit mindestens einer Schale (7) aus magnetisch und / oder elektrisch gut leitendem Material verbunden sind.

2. Vorrichtung nach Anspruch 1, **dadurch gekennzeichnet,** daß die Abschirmkabine (1) im Kabinenraum (4) auf einem Fundament (11) steht, dessen Dicke zwischen dem Boden (10) des Kabinenraumes (4) und dem Boden der Abschirmkabine etwa den gleichen Abstand gewährleistet, wie er zwischen der äußeren Schale (3) der Abschirmkabine (1) und den Wänden (6) und der Decke (7) des Kabinenraumes (4) vorhanden ist.

3. Vorrichtung nach Anspruch 1, **dadurch gekennzeichnet,** daß die Schale (7) zur zusätzlichen Abschirmung des Kabinenraumes (4) an den Innenseiten der Wände (6), der Decke (7) und des Bodens (10) angebracht ist.

4. Vorrichtung nach Anspruch 1, **dadurch gekennzeichnet,** daß der Zugang zum Kabinenraum über einen ebenfalls mit einer Schale aus abschirmendem Material ausgekleideten Zugangstunnel (8) erfolgt.

5. Vorrichtung nach Anspruch 1, **dadurch gekennzeichnet,** daß der Kabinenraum (4) durch eine mit einer Schale aus abschirmendem Material versehene Schiebetür zugänglich ist.

## Claims

1. Device for shielding the interior of a shielding cabin (1), which consists of at least two shells (2, 3, 5) which are made of a material which is a good magnetic and/or electrical conductor and are secured to a carrier structure, characterised in that for improvement of the shielding effect the shielding cabin (1) is erected with a gap in a cabin chamber (4) whose walls (6) including the ceiling (9) and floor (10) are also connected with at least one shell (7) made of a material which is a good magnetic and/or electrical conductor.

2. Device according to claim 1, characterised in that the shielding cabin (1) stands in the cabin chamber (4) on a base (11) whose thickness between the floor (10) of the cabin chamber (4) and the floor of the shielding cabin guarantees roughly the same gap as is present between the outer shell (3) of the shielding cabin (1) and the walls (6) and the ceiling (7) of the cabin chamber (4).

3. Device according to claim 1, characterised in that the shell (7) for additional shielding of the cabin chamber (4) is attached to the insides of the walls (6), the ceiling (7) and the floor (10).

4. Device according to claim 1, characterised in that access to the cabin chamber is effected by means of an access tunnel (8) also lined with a shell of shielding material.

5. Device according to claim 1, characterised in that the cabin chamber (4) is accessible through a sliding door provided with a shell of shielding material.

## Revendications

1. Dispositif pour l'isolation de l'espace interne d'une cabine d'isolation (1), qui est constitué d'au moins deux enveloppes (2, 3, 5) en un matériau magnétiquement et/ou électriquement conducteur, fixées sur une construction porteuse,
dispositif caractérisé en ce que la cabine d'isolation (1), pour améliorer l'effet d'isolation, est installée, en ménageant un intervalle, dans une chambre de cabine (4), dont les parois (6), y compris le plafond (9) et le plancher (10), sont également reliées par au moins une enveloppe (7) en un matériau magnétiquement et/ou électriquement bon conducteur.

2. Dispositif selon la revendication 1, caractérisé en ce que la cabine d'isolation (1) est placée dans la chambre de cabine (4) sur un fondement (11), dont l'épaisseur entre le plancher (10) de la chambre de cabine (4) et le plancher de la cabine d'isolation (1) garantit à peu près le même intervalle que celui existant entre l'enveloppe externe (3) de la cabine d'isolation (1) et les parois (6) et le plafond (9) de la chambre de cabine (4).

3. Dispositif selon la revendication 1, caractérisé en ce que l'enveloppe (7), pour l'isolation supplémentaire de la chambre de cabine (4), est rapportée sur les côtés internes des parois (6), du plafond (9) et du plancher (10).

4. Dispositif selon la revendication 1, caractérisé en ce que l'accès à la chambre de cabine s'effectue par un tunnel d'accès (8), également revêtu d'une enveloppe en un matériau isolant.

5. Dispositif selon la revendication 1, caractérisé en ce que la chambre de cabine (4) est accessible par une porte coulissante munie d'une enveloppe en un matériau isolant.
